# EUROPEAN PATENT APPLICATION

(11) **EP 4 738 402 A1**
(43) Date of publication of application: **06.05.2026**
(21) Application number: 24306844.2
(22) Date of filing: 31.10.2024
(51) Int. Cl.: H01G 4/012, H01G 4/228, H01G 4/33, H01G 4/06, H01G 4/005, H01G 4/38, H10D 1/68

(54) **ELECTRICAL DEVICE COMPRISING A CAPACITOR FORMED USING A POROUS STRUCTURE AND CONDUCTIVE WIRES**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: BUFFLE, Larry, 14000 CAEN (FR); VOIRON, Frédéric, 14000 CAEN (FR); ARCHAMBAULT, Sophie, 38054 Grenoble cedex 09 (FR)
(74) Representative: Cabinet Beau de Loménie

(57) **Abstract**

The present invention relates to an electrical device and a method for manufacturing thereof. The proposed device (100) comprises a capacitor including a porous structure (300), the porous structure (300) comprising:
- a first electrode region (310) comprising first pores (311), wherein these first pores (311) comprise first conductive wires (312),
- a second electrode region (320) comprising second pores (321), wherein these second pores (321) comprise second conductive wires (322), and
- a dielectric region (330) comprising third pores (331) and interposed between the first and second electrode regions (310, 320),
wherein the capacitor is formed by the first pores (311) of the first electrode region (310) and the second pores (321) of the second electrode region (320) facing each other and being separated by the third pores (331) of the dielectric region (330).

## Description

### Field of the Invention

The present invention relates to the field of electrical devices. More particularly, it relates to an electrical device comprising a capacitor and a method for manufacturing thereof.

### Description of Related Art

The present invention lies in particular within the context of electrical devices comprising capacitors with a high capacitance density and suited for high voltage applications.

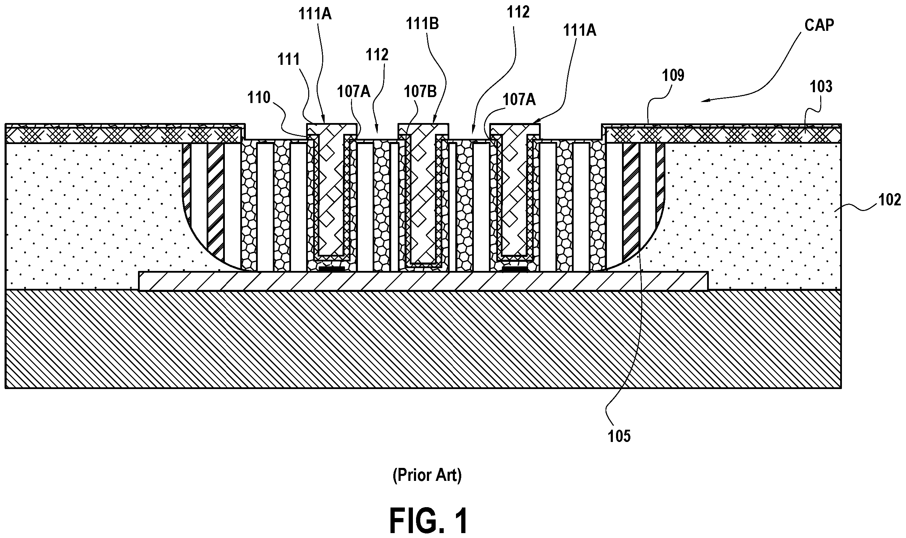

In this context, the capacitor of application EP 3 992 999 A1 (hereinafter EP999 and which is hereby incorporated by reference) has been proposed. As illustrated on FIG. 1, this capacitor CAP is formed using a porous structure 105. The latter is filled with dielectric material 109 to form the capacitor dielectric 112. The capacitor electrodes 111A-111B are formed using trenches 107A-107B etched in the porous structure 105 and filled with conductive material 111.

The capacitor proposed in EP999 is particularly advantageous in that it allows using thin layer deposition techniques, such as atomic layer deposition (ALD), to deposit dielectric material 109 in the pores of the porous structure 105 and obtain a thick capacitor dielectric 112 capable of withstanding high voltages.

However, emerging applications, such as electric cars, require even higher capacitance density and the capability to reliably withstand even higher voltages (e.g., exceeding 900V, or 1200V).

Therefore, the present invention aims to improve the capacitor of application EP999 in view of achieving higher capacitance density and withstand higher voltages.

### Summary of the Invention

According to an aspect, the present invention provides an electrical device comprising a capacitor including a porous structure, the porous structure comprising:
- a first capacitor electrode region comprising first pores, wherein the first pores of this region comprise (are partially or fully filled by) first conductive wires,
- a second capacitor electrode region comprising second pores, wherein the second pores of this region comprise (are partially or fully filled by) second conductive wires (the first and second capacitor electrode regions are disjoint regions, the first and second pores are distinct pores, and the first and second conductive wires are distinct wires), and
- a capacitor dielectric region comprising third pores and interposed between the first and second capacitor electrode regions,
   wherein the capacitor is formed by the first pores of the first capacitor electrode region and the second pores of the second capacitor electrode region facing each other and being separated by the third pores of the capacitor dielectric region.

The present invention proposes forming the capacitor electrodes by growing conductive nanowires in the pores of the porous structure (e.g., an anodized aluminum oxide structure). This provides several advantages (in addition to those of the capacitor of application EP999).

First, the proposed electrical device allows achieving a higher capacitance density.

In the capacitor of application EP999, the electrodes are formed by deposing conductive material in trenches using electrodeposition (ELD). As detailed hereinafter, this deposition technique limits the maximum thickness that can be used for the porous structure (unless the trenches are widened, and thus the capacitance density reduced).

In contrast, the capacitor electrodes of the proposed electrical device are formed by growing (e.g., using ALD) nanowires in the pores of the porous structure. This can be achieved even for a particularly thick porous structure. The porous structure in the proposed device may be 10, 50, 100, or even 200µm thick.

The proposed device hence allows forming the capacitor using a porous structure thicker than that of the capacitor of application EP999. It follows that the capacitor of the proposed device has a larger surface area of electrodes facing each other along the vertical direction (i.e., along the z-axis) and thus a higher capacitance density.

Second, the proposed device allows reducing mechanical stress.

In the capacitor of application EP999, the electrodes are formed by trenches in the porous structure fully filled with conductive material. Such monolithic electrodes can contribute to building mechanical stress within the capacitor.

In contrast, the use of nanowires arranged in pores relaxes the mechanical stress within the capacitive structure. This contributes to preventing cracks and thus to reliably withstanding high voltages.

For these reasons, the present invention provides an electrical device comprising a capacitor with a high capacitance density and able to withstand reliably high voltages.

In a particular embodiment, the first and second conductive wires fill (completely) the first and second pores of the first and second capacitor electrode regions.

In this embodiment, the pores of the electrode regions of the porous structure are fully filled by the conductive wires. That is, there is no volumes remaining empty in the center of the pores of the electrode regions. This contributes to reducing the resistance of the capacitor along the vertical direction (i.e., along the z-axis).

In a particular embodiment, the first and second conductive wires fill (only) partially the first and second pores of the first and second capacitor electrode regions, volumes remaining empty (void) in (the center of) these pores.

In this embodiment, the conductive wires do not fill completely the pores of the electrode regions. That is, the center of the pores remains unfilled. This embodiment provides multiples advantages. It allows reducing the time for manufacturing the electrical device (it is not necessary to grow wires up to the full filling of the pores). It also contributes to further reducing the mechanical stress within the capacitor.

In a particular embodiment, the capacitor further comprises:
- a first connection region comprising (filled with) conductive material (such as tungsten, aluminum, or copper) electrically connecting the first conductive wires of the (different) first pores of the first capacitor electrode region, and
- a second connection region comprising (filled with) conductive material (such as tungsten, aluminum, or copper) electrically connecting the second conductive wires of the (different) second pores of the second capacitor electrode region.

In this embodiment, the conductive wires from different pores are connected using the connection regions filled with conductive material. This allows electrically connecting the wires forming the capacitor electrodes.

In a particular embodiment, the first and second capacitor electrode regions of the porous structure comprise respectively first and second recesses so that a top surface (the highest surface) of the first and second pores lies below a top surface (the highest surface) of the porous structure.

And, the first and second connection regions extend respectively in (fill partially or completely) the recesses of the first and second capacitor electrode regions so that a top surface (the highest surface) of the first and second connection regions lies below or (substantially) at the level of the top surface of the porous structure.

Here, the connection regions (electrically connecting the conductive wires forming the capacitor electrodes) are confined within the porous structure. Specifically, the connection regions extend in the recesses of the capacitor electrode regions, but do not protrude above the porous structure.

It follows that a greater part of the electrostatic field is confined within the porous structure (comprising the desired dielectric) which allows maintaining a greater part of the electrostatic field out of structural weak points (i.e., geometrical singularities, weaker layers). This embodiment allows preventing local increases in the electrostatic field and thus reducing the leakage current in the capacitor. This contributes to reliably withstanding high voltages.

Alternative embodiments could be envisaged. As detailed hereinafter, the connection regions could be located elsewhere in the capacitor. For instance, they could extend above and/or below the porous structure (rather than in the recesses of the porous structure).

In a particular embodiment, a thickness of the first and second connection regions is comprised between 100nm and 3µm.

The thickness of the connection regions along the vertical direction (i.e., along the z-axis) represents a tradeoff between: (i) the manufacturing time (required to form the recesses in the porous structure and deposit conductive material to fill these recesses), and (ii) the resistance of the capacitor in the horizontal plan (i.e., in the plan x-y). The thickness of the connection regions should therefore be set according to the application envisaged for the capacitor.

If the capacitor resistance is not critical to the envisaged application, the connection regions may be relatively thin (e.g., between 100nm and 1 µm) to ensure rapid manufacturing. Conversely, if the capacitor resistance is required to be minimum for the envisaged application, the connection regions may be thicker (e.g., between 1 and 3 µm).

In a particular embodiment, the porous structure comprises pores extending up to lateral edges (die edges) of the electrical device (a full-sheet porous structure is used).

This embodiment proposes using a full-sheet porous structure. This has several advantages.

First, it simplifies the manufacturing process of the proposed electrical device. Various manufacturing steps can be performed on the full sheet and thus less patterning is required. Patterning contributes to the formation of surface irregularities (or requires an appropriate process to eliminate these irregularities, such as chemical-mechanical polishing). For this reason, this embodiment (which requires less patterning) allows the different layers forming the capacitor to retain a flatter surface.

Second, let us consider that an anodic aluminum oxide (AAO) structure is used to form the proposed electrical device.

If this structure does not have pores over its entire surface (it is not a full-sheet porous structure), there is an expansion of the structure at the transition between the aluminum region and the AAO region. More specifically, during the anodizing process to form the porous AAO structure, the aluminum absorbs oxygen atoms and inflates. With reference to FIG. 1, at the interface between the porous AAO region 105 and the remaining aluminum region 102, this volume difference deforms the layer 103. This may result in cracks in the structure and numerous surface irregularities that are then difficult to remove. The extent of this expansion is related to the thickness of the structure. For this reason, the maximum thickness of the structure that can be used would be limited to prevent cracks.

In contrast, the use of an AAO structure with pores over its entire surface (it is a full-sheet porous structure) overcomes this limitation. With full sheet anodization, surface irregularities can be significantly reduced, as the flatness problem is shifted from the capacitive area to the wafer edge (where no product is built and therefore cracks may not be a problem). It is then possible to use a significantly thicker porous structure, which increases the capacitance density.

Third, this embodiment allows using a porous structure manufactured ex-situ and then placed on a substrate.

In a particular embodiment, all, or part of the third pores of the capacitor dielectric region comprise (are fully or partially filled with) dielectric material (such as silicon oxide and/or hafnium oxide and/or aluminum oxide).

This embodiment allows achieving a stronger dielectric strength and contributes to withstanding reliably high voltages.

Alternatively, it could be envisaged to maintain the pores of the capacitor dielectric region empty. The dielectric region with empty pores (with the vacuum achieved during manufacture) may have a sufficient dielectric strength for certain applications. This allows simplifying the manufacturing of the proposed device. For certain applications, empty pores could also be used to create areas (e.g., with other electrical elements/components) where the parasitic capacitance is maintained as low as possible.

In a particular embodiment, the first and second capacitor electrode regions are arranged in an interlocking-comb structure or an interlocking spiral structure (the capacitor dielectric region being interposed in between).

This arrangement of the capacitor electrodes maximizes the surface area used to form the capacitor. An increased capacitance density follows as a result.

In a particular embodiment, the electrical device is configured to be used with an operating voltage measured between the first conductive wires of the first capacitor electrode region and the second conductive wires of the second capacitor electrode region exceeding 900V or 1200V.

According to another aspect, the present invention provides a method for manufacturing an electrical device comprising a capacitor, the method comprising:
- providing a porous structure,
- forming first conductive wires in first pores of a first capacitor electrode region of the porous structure (e.g., using ALD),
- forming second conductive wires in second pores of a second capacitor electrode region of the porous structure (e.g., using ALD), and
wherein:
- the porous structure comprises a capacitor dielectric region comprising third pores and interposed between the first and second capacitor electrode regions, and
- the capacitor is formed by the first pores of the first capacitor electrode region and the second pores of the second capacitor electrode region facing each other and being separated by the third pores of the capacitor dielectric region.

The proposed manufacturing method can be adapted to obtain any one of the electrical devices defined in the present disclosure.

The embodiments of the proposed method for manufacturing an electrical device present the advantages described in relation with the embodiments of the proposed electrical device.

In a particular embodiment, the method comprises:
- depositing, on the porous structure, a mask comprising:
   ∘ at least one solid portion defining the first and second capacitor electrode regions,
   ∘ at least one opening defining the capacitor dielectric region,
- depositing dielectric material in the third pores of the capacitor dielectric region (through the at least one opening of the mask), and
- removing the mask before forming the first and second conductive wires in the first and second pores of the first and second capacitor electrode regions.

Here, a single hard mask is used to define both the capacitor dielectric region and the capacitor electrodes regions of the porous structure. The alignment of the capacitor dielectric and the capacitor electrodes is achieved in a single operation. This contributes to withstand reliably high voltages.

Thanks to this embodiment, it is not necessary to use multiple masks to define the electrode regions and the dielectric region of the porous structure. The use of multiple masks would lead to alignment problems between the capacitor electrodes and the capacitor dielectric, which would adversely affect the breakdown voltage of the capacitor and hence its capability to withstand high voltages.

In a particular embodiment, the method comprises:
- etching first and second recesses respectively in the first and second capacitor electrode regions so that a top surface of the first and second pores of these regions lies below a top surface of the porous structure, and
- depositing a layer of conductive material on the porous structure to form:
   ∘ a first connection region extending in the recesses of the first capacitor electrode region and electrically connecting the first conductive wires of this region, and
   ∘ a second connection region extending in the recesses of the second capacitor electrode region and electrically connecting the second conductive wires of this region,
      - planarizing the layer of conductive material so that a top surface of the first and second connection regions lies below or substantially at the level of the top surface of the porous structure.

In a particular embodiment, providing the porous structure comprises anodizing an aluminum layer to form pores on substantially an entire surface of this layer (full-sheet anodizing, maskless anodizing).

In another embodiment, providing the porous structure comprises placing (e.g., sticking) an anodic aluminum oxide structure (manufactured ex-situ) on a substrate.

In a particular embodiment, the method comprises depositing dielectric material in the third pores of the dielectric region using atomic layer deposition.

### Brief Description of the Drawings

Further features and advantages of the present invention will become apparent from the following description of certain embodiments thereof, given by way of illustration only, not limitation, with reference to the accompanying drawings in which:
FIG. 1 illustrates the capacitor proposed in application EP999,
FIG. 2 illustrates a cross-section view of an electrical device according to an embodiment of the invention,
FIGS. 3A to 3H illustrate steps of a method for manufacturing an electrical device according to an embodiment of the invention,
FIGS. 4A and 4B illustrate cross-section views of electrical devices according to embodiments of the invention,
FIGS. 5A and 5B illustrate simulation results relating to the electrostatic field in electrical devices according to embodiments of the invention, and
FIG. 6 illustrates a top view of an electrical device according to an embodiment of the invention.

### Detailed Description of Example Embodiments

The present invention provides an electrical device with a high capacitance density and suited for high voltage applications. More specifically, embodiments of the present invention seek to improve the capacitor proposed in application EP999 in terms of capacitance density and capability to withstand high voltages.

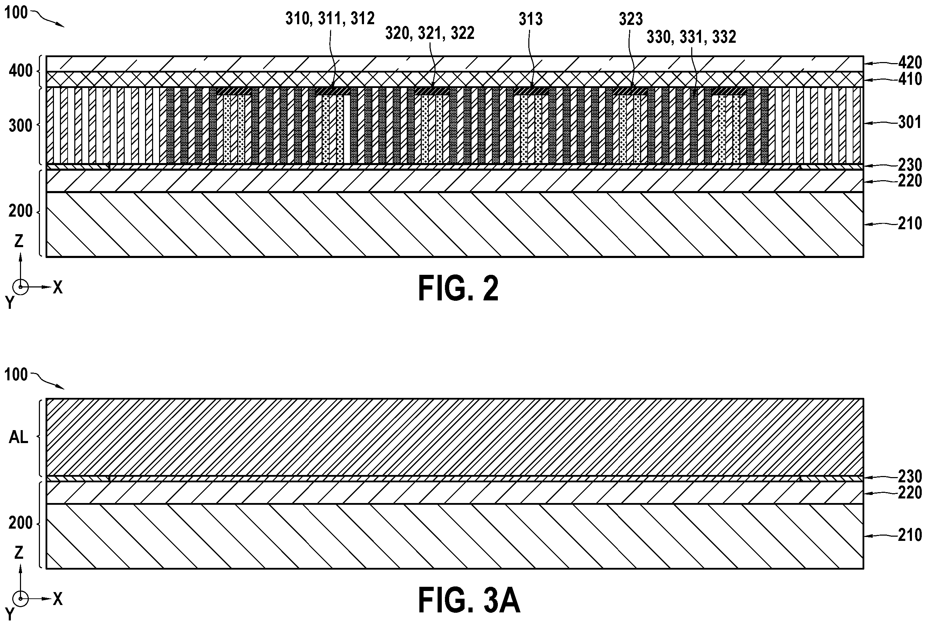

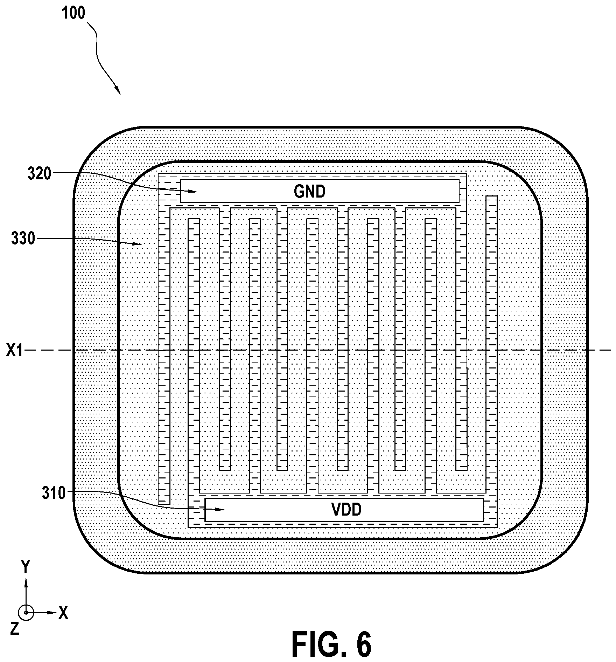

**FIG. 2** illustrates a cross-section view of an electrical device according to an embodiment of the invention. Specifically, this figure shows a cross-section of the proposed electrical device 100 along the axis X1 illustrated on FIG. 6.

The electrical device 100 comprises here a substrate structure 200, a porous structure 300, and an insulating structure 400. We detail these structures below.

The substrate structure 200 comprises a substrate 210 (e.g., a conductor, a semi-conductor, or even an insulator substrate). For instance, the substrate 210 may be a silicon substrate.

One or more dielectric layers 220-230 may be formed on the substrate 210. For instance, a silicon oxide (SiO2) layer 220 may be formed using thermal oxidation of the silicon substrate 210, and thereupon another silicon oxide layer 230 may be formed using TEOS (i.e., by chemical vapor deposition of tetraethylorthosilicate).

The porous structure 300 comprises a first capacitor electrode region 310, a second capacitor electrode region 320, and a capacitor dielectric region 330 (these are disjoint regions of the porous structure).

Before detailing these different regions 310-330, it should be noted that the porous structure 300 comprises pores 301 extending up to the lateral edges of the electrical device 100 (i.e., the die edges). The pores 301 extend downwards from the top surface of the porous structure 300 and may extend up to the bottom surface of the porous structure 300. These pores 301 are (substantially) vertical and (substantially) perpendicular to the top surface of the porous structure 300. As illustrated here, the porous structure 300 is continuous and comprises pores 301 (evenly) distributed over its entire surface.

For instance, the porous structure 300 may be an anodic aluminum oxide (AAO) structure. However, within the scope of the invention, other embodiments could also be envisaged wherein other porous structures are used.

The first capacitor electrode region 310 (e.g., the VDD electrode on FIG. 6) comprises first pores 311. All or part of the first pores 311 of this region 310 comprise first conductive wires 312 (e.g., nanowires). In other words, the first conductive wires 312 are arranged in all or part of the first pores 311 of this region 310.

The second capacitor electrode region 320 (e.g., the GND electrode on FIG. 6) comprises second pores 321. All or part of the second pores 321 of this region 320 comprise second conductive wires 322 (e.g., nanowires). In other words, the second conductive wires 322 are arranged in all or part of the second pores 321 of this region 320. The first and second pores 311-321 are distinct pores of the porous structure 300.

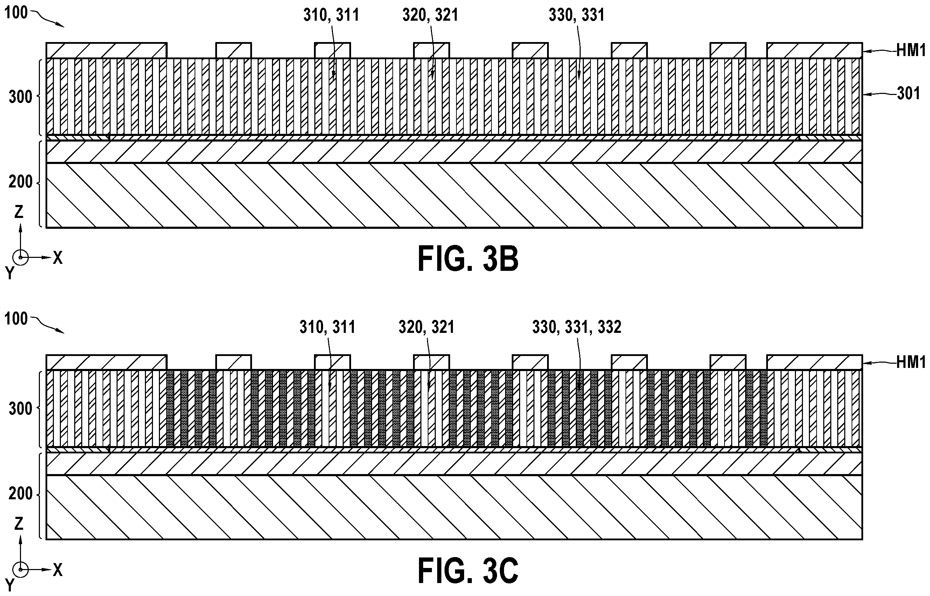

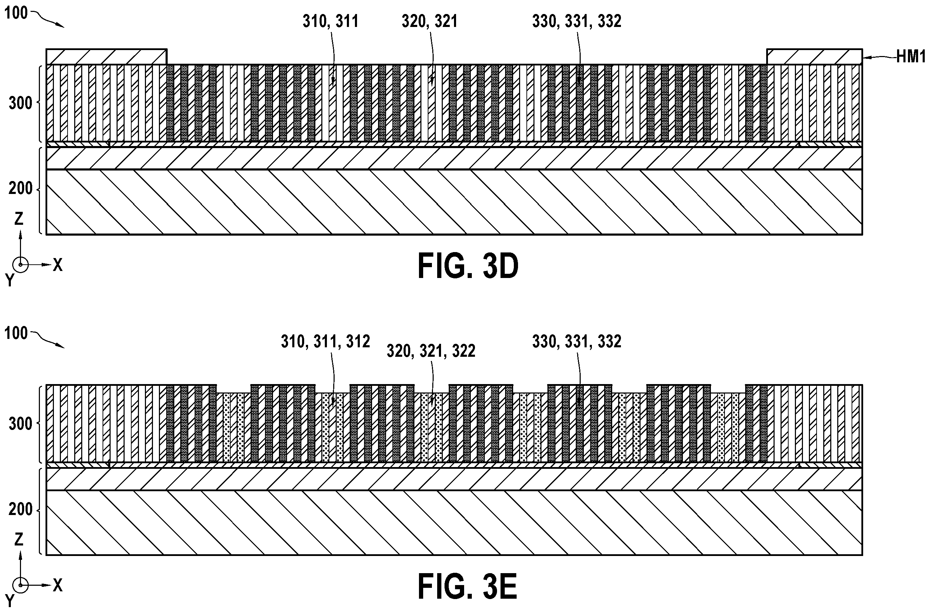

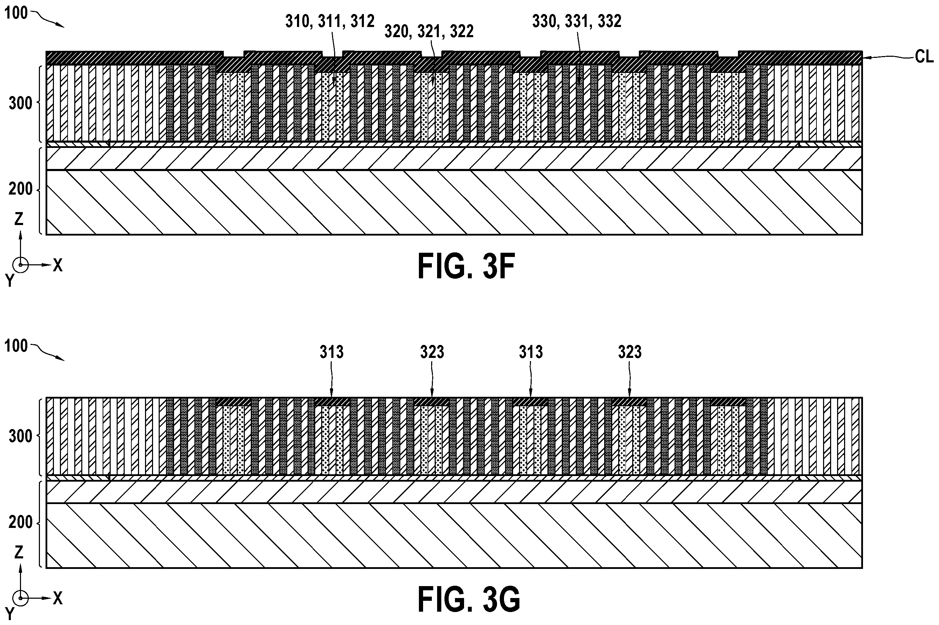

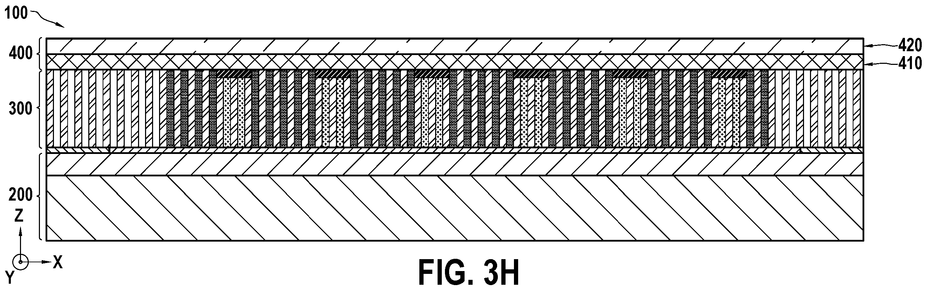

The conductive wires 312 and 322 create respectively an array that acts electrostatically as an iso-potential equivalent to a monolithic electrode. More specifically, the conductive wires 312 and 322 form respectively an iso-potential equivalent to a monolithic electrode when the distance between the conductive wires is small (*e.g.,* <1/10) relative to the dielectric thickness. In other words, the closer the conductive wires are, the more valid their iso-potential property. For example, the manufacturing process may include anodizing an aluminum layer such that the conductive wires 312-322 may be formed at a distance of a few tens of nm (~10-100nm) from each other, while the thickness of dielectric 330 may vary from 1µm to several µm (for high-voltage applications). We detail below in reference to FIG. 3 how the conductive wires 312 and 322 are formed.

In the present disclosure, we use the term "conductive wires" to refer to a layer of conductive material extending into the pores of the porous structure. The conductive wires partially or completely fill the pores of the porous structure.

The capacitor dielectric region 330 comprises third pores 331 and is interposed between the first capacitor electrode region 310 and the second capacitor electrode region 320 to form the capacitor of the electrical device 100.

The first capacitor electrode region 310 and the second capacitor electrode region 320 face each other and are separated by the capacitor dielectric region 330, thereby forming the capacitor of the electrical device 100. In other words, the capacitor is formed by the first pores 311 of the first capacitor electrode region 310 and the second pores 321 of the second capacitor electrode region 320 facing each other and separated by the third pores 331 of the capacitor dielectric region 330.

All or part of the third pores 331 of the capacitor dielectric region 330 may comprise dielectric material 332. For instance, these pores 331 may be filled with silicon oxide (SiO2) and/or hafnium oxide (HfO2) and/or aluminum oxide (Al2O3) using ALD. Other embodiments could also be envisaged in which the pores 331 of this region 330 are maintained empty (as previously discussed).

Furthermore, the electrical device 100 comprises a first connection region 313 and a second connection region 323.

The first connection region 313 comprises conductive material (e.g., tungsten, or aluminum, or copper, or copper with a barrier layer) that electrically connects the first conductive wires 312 of the different first pores 311 of the first capacitor electrode region 310.

The second connection region 323 comprises similarly conductive material (e.g., tungsten, or aluminum, or copper, or copper with a barrier layer) that electrically connects the second conductive wires 322 of the different second pores 321 of the second capacitor electrode region 320.

We detail below in reference to FIG. 3 how the connection regions 313 and 323 are formed.

The insulating structure 400 comprises one or more insulating layers 410-420 extending on the porous structure 300. For instance, the insulating structure 400 may comprise a stack of a silicon oxide (SiO2) layer 410 and a silicon nitride (Si3N4) layer 420.

The proposed electrical device 100 has several advantages.

Similarly to the capacitor of application EP999, the proposed electrical device 100 allows using ALD techniques to deposit dielectric material 332 in the pores 331 of the porous structure 300 and obtain a thick capacitor dielectric 112 capable of withstanding high voltages. In other words, the use of the porous structure 300 to form the capacitor allows using thin-film technologies for high-voltage applications (the porous structure 300 serving as a 3D support for the deposition of materials using ALD).

In addition to the advantages of the capacitor of application EP999, the proposed electrical device 100 provides the following advantages. These additional advantages result from forming the capacitor electrodes by using conductive wires in the pores of the porous structure.

In the capacitor of application EP999, the electrodes 111A-111B are formed using trenches 107A-107B etched in the porous structure 105 and filled with conductive material 111 using ELD. With ELD, it is necessary to use a seed layer 110 that is deposited by pressure vapor deposition (PVD) or chemical vapor deposition (CVD). This limits the aspect ratio (width to depth ratio) that can be used for trenches 107A-107B (e.g., less than 1/5 or 1/10). For a thick porous structure 105 (e.g., thicker than 10 or 100 µm), this deposition technique requires the use of wider trenches 107A-107B (e.g., larger than 1 or 10 µm) to form the capacitor electrodes 111A-111B. This adversely affects the capacitance density of the capacitor.

In contrast, the use of conductive wires 312-322 grown (using ALD) in pores 311-321 to form the capacitor electrodes 310-320 overcomes the above-mentioned limitation concerning the aspect ratio of the electrodes. The width of the capacitor electrodes 310-320 can be reduced to a few pores (even for a particularly thick porous structure 300). For instance, electrodes 310-320 with a width of 0.25 µm can be used for a porous structure 300 with a thickness of 10, 50 or 100 µm. This increases the surface area of capacitor electrodes facing each other, and thus improves the capacitance density.

Furthermore, the proposed electrical device 100 allows reducing mechanical stress in the capacitive structure.

In the capacitor of application EP999, the electrodes 111A-111B are formed using trenches 107A-107B etched in the porous structure 105 and filled with conductive material 111. These monolithic electrodes 111A-11B can contribute to building mechanical stress within the capacitor.

In contrast, the use of nanowires allows reducing mechanical stress within the capacitive structure. This contributes to preventing cracks and thus to reliably withstanding high voltages.

Thereby the present invention provides an electrical device 100 comprising a capacitor with a high capacitance density and able to withstand reliably high voltages.

For instance, the electrical device 100 may be configured to be used with an operating voltage measured between the first capacitor electrode region 310 and the second capacitor electrode region 320 exceeding 900 V, or 1 200 V.

We have described above the general structure of the proposed electrical device 100. Below we describe the proposed method for manufacturing this device 100 and further detail certain features of this device 100.

**FIGS. 3A to 3H** illustrate steps of a method for manufacturing an electrical device according to an embodiment of the invention.

The proposed method for manufacturing the electrical device 100 comprises (all or part of) the following steps.

FIG. 3A illustrates a step in which the substrate structure 200 is provided. As illustrated, an aluminum layer AL extends on the substrate structure 200. This layer AL is used to form the porous structure 300, as detailed below.

FIG. 3B illustrates a step in which the porous structure 300 is formed by anodizing of the aluminum layer AL (alternatively, the porous structure 300 could be manufactured ex-situ and then placed on the substrate structure 200). The thickness of the porous structure 300 may, for instance, be comprised between 10 and 200µm.

The pores 301 of the porous structure 300 are (substantially) vertical and (substantially) perpendicular to the top surface of the porous structure 300. With an anodized aluminum oxide structure, the pores 301 have typically a diameter of the order of tens of nanometers (e.g., a diameter of about 80nm).

In this embodiment, the pores 301 extend up to the lateral edges of the electrical device 100. It means that the anodizing of the aluminum layer AL is performed over (substantially) its entire surface area (i.e., full-sheet anodizing, maskless anodizing). The use of a full-sheet AAO structure 300 has several advantages.

This figure also illustrates a step in which a mask HM1 is formed on the porous structure 300.

On the one hand, the solid portions of this mask HM1 define the electrode regions 310-320 (the pores 311-321 of the electrode regions 310-320 are located below the solid portions of this mask HM1). On the other hand, the openings of this mask HM1 define the dielectric region 330 (the pores 331 of the dielectric region 330 are located below the openings of this mask HM1).

It is important to note that a single hard mask HM1 is used to define both the dielectric region 330 and the electrodes regions 310-320. This ensures a perfect alignment of the capacitor dielectric region and the capacitor electrode regions (in a single operation). This is particularly important to withstand high voltages (as previously discussed).

The width and separation of the electrode regions 310-320 are set (using the hard mask HM1) depending on the application envisaged for the electrical device 100, in view of the required ESR/ESL and capacitance/breakdown voltage.

FIG. 3C illustrates a step in which (all or part of) the third pores 331 of the dielectric region 330 are filled with dielectric material 332. For instance, these pores 331 may be filled with silicon oxide (SiO2) and/or hafnium oxide (HfO2) and/or aluminum oxide (Al2O3) using ALD. This allows achieving a stronger dielectric strength and contributes to withstanding reliably high voltages.

FIG. 3D illustrates a step in which the solid portions of the mask HM1 are etched. As illustrated on this figure, the mask HM1 is partially etched. The portions of the mask HM1 etched in this step correspond to the portions defining the electrodes regions 310-320.

FIG. 3E illustrates a step in which first and second recesses are respectively etched in the first and second capacitor electrode regions 310-320. The top surface of the first and second pores 311-321 of the first and second capacitor electrode regions 310-320 lies below the top surface of the porous structure 300.

This figure also illustrates a step in which the first and second conductive wires 312-322 are formed (grown) in the pores 311-322 of the electrode regions 310-320.

In an embodiment, the conductive wires 312-322 fill completely (all or part of) the pores 311-321 of the electrode regions 310-320. There are no volumes remaining empty in the center of the pores 312-322 of the electrode regions 310-320. This embodiment contributes to reducing the resistance of the capacitor along the vertical direction (i.e., along the z-axis).

In another embodiment, the conduct wires 312-322 fill (only) partially the pores 311-321 of the electrode regions 310-320. Volumes remaining empty in the center of these pores 311-321. This embodiment allows reducing the manufacturing time and contributes to reducing the mechanical stress within the capacitor.

The conductive wires 312-322 of the electrode regions 310-320 can be made in different material. They may be titanium nitride (TiN) wires (directly) grown on the pores 311-321 of the electrode regions 310-320, or ruthenium (Ru) wires (directly) grown on the pores 311-321 of the electrode regions 310-320. The conductive wires 312-322 can also be ruthenium (Ru) wires grown on a titanium nitride (TiN) layer (i.e., a seed layer) extending conformally over the pores of the electrode regions 310-320. The use of a seed layer in titanium nitride allows catalyzing the growth of the ruthenium wires.

The conductive wires 312-322 are formed using ALD. As previously discussed, the use of ALD to grow the conductive wires 312-322 in the pores 311-321 allows a particularly thick porous structure 300 (and whose pores have a high aspect ratio) to be used to form the capacitor. This provides a capacitor with a high capacitance density.

However, the present invention is not limited to the use of ALD to form the conductive wires, and other deposition techniques could be considered. For instance, ELD could be used, but this would entail constraints on the aspect ratio of the pores and therefore on the thickness of the porous structure. Conductive wires fully filling the pores could be grown from the bottom to the top using ELD, or hollow conductive wires partially filling the pores could be grown from the vertical sides of the pores using ELD with a seed layer.

FIG. 3E also illustrates a step in which the remaining of the mask HM1 is removed.

FIG. 3F illustrates a step in which a conductive layer CL is deposited on the porous structure 300. The conductive layer CL may be a layer comprising tungsten (e.g. deposited using CVD with deep recess), or aluminum, or copper. The conductive layer CL may also be a composite layer of an aluminum or copper layer and a barrier layer like titanium or tungsten.

As illustrated in this figure, the conductive layer CL fills (partially or fully) the recesses in the electrode regions 310-320.

FIG. 3G illustrates a step in which the conductive layer CL is planarized so that the top surface of the conductive layer CL lies below or substantially at the level of the top surface of the porous structure 300. For instance, this step can be performed using chemical-mechanical polishing (CMP).

This step results in the forming of the connection regions 313-323. The first connection region 313 electrically connects the first conductive wires 312 of the first pores 311 of the first capacitor electrode region 310, and the second connection region 323 electrically connects the second conductive wires 322 of the second pores 321 of the second capacitor electrode region 320.

Here, the connection regions 313-323 are confined within the porous structure 300. The top surface of the connection regions 313-323 lies (substantially) at the level of the top surface of the porous structure 300. Thereby, a greater part of the electrostatic field is confined within the porous structure 300 (comprising the desired dielectric material 332) which allows maintaining a greater part of the electrostatic field out of structural weak points (i.e., geometrical singularities, weaker layers). This allows preventing local increases in the electrostatic field.

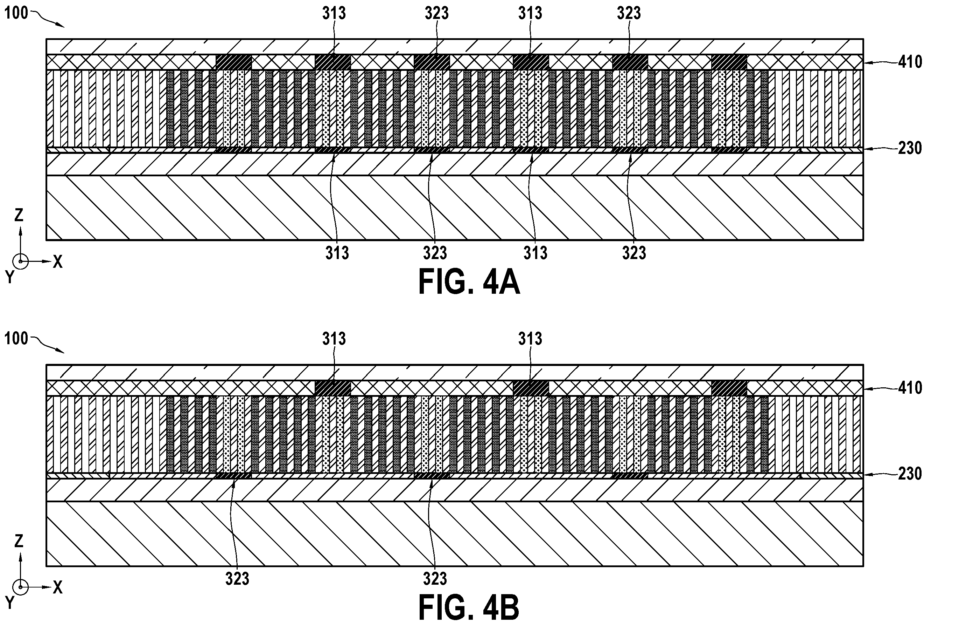

Within the scope of the present invention, alternative embodiments could be envisaged. The connection regions could be located elsewhere in the capacitor. Such alternatives embodiments are presented below in reference to FIGS. 4A and 4B.

The thickness of the first and second connection regions 313-323 is comprised between 100nm and 3µm. The thickness of the connection regions 313-323 should be set according to the application envisaged for the capacitor, in view of the above-mentioned tradeoff between manufacturing time and capacitor resistance.

FIG. 3H illustrates a step in which the insulating structure 400 is formed.

As mentioned above, the connection regions 313-323 can be implemented in several ways. We describe below, in reference to FIGS. 4A and 4B, alternative embodiments to the embodiment illustrated in FIG. 2.

**FIGS. 4A and 4B** illustrate cross-section views of electrical devices according to embodiments of the invention.

FIG. 4A illustrates an embodiment wherein each of the connection regions 313-323 extend both above and below the porous structure 300 (rather than in recesses of the porous structure).

In contrast to the embodiment shown in FIG. 2, this embodiment does not require recesses to be etched in the porous structure 300 to form the connection regions 313-323 (but other additional manufacturing steps are required).

With the connection regions 313-323 extending above and below the porous structure 300, this embodiment is advantageous in that it contributes to reducing the capacitor resistance (at least in the x-y plan).

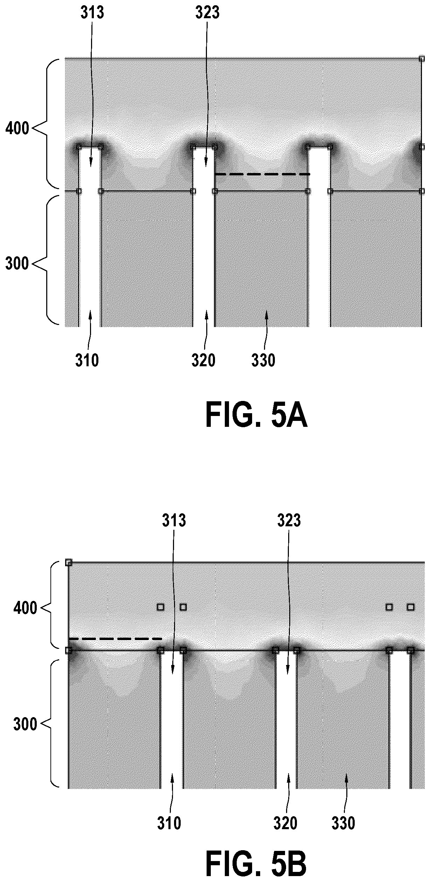

However, the connection regions 313-323 extend here into the insulating layer 410 (which may have a lower dielectric strength than the dielectric region 330 comprising the dielectric material 332). This embodiment may therefore result in potential local increases in the electrostatic field (in comparison with the embodiment of FIG. 2). We detail this aspect below in reference to FIGS. 5A and 5B.

FIG. 4B illustrates an embodiment wherein the first connection region 313 extends above the porous structure 300 and the second connection region 323 extends below the porous structure 300.

In contrast to the embodiment shown in FIG. 2, this embodiment also does not require recesses to be etched in the porous structure 300 (but other additional manufacturing steps are required).

With the connection regions 313 and 323 extending respectively above and below the porous structure 300, this embodiment is advantageous in that it contributes to reducing local increases of the electrostatic field in the capacitor (in comparison with the embodiment of FIG. 4A).

Furthermore, regarding the implementation of connection regions 313-323, it could be envisaged to combine the above-mentioned (and technically compatible) embodiments.

For example, the embodiments of FIGS. 2 and 4B could be combined. That is, the connection regions 313-323 could extend both in recesses of the porous structure, as well as above and below the porous structure. Such an implementation allows reducing the capacitor resistance while preventing local increases in the electrostatic field.

After presenting different embodiments regarding the implementation of the connection regions 313-323, we compare these embodiments in terms of the electrostatic field in reference to the following figures.

**FIGS. 5A and 5B** illustrate simulation results relating to the electrostatic field in electrical devices according to embodiments of the invention.

Specifically, these figures show the intensity of the electrostatic field in the electrical device 100 for different embodiments. In these embodiments, the capacitor dielectric region 330 is formed by depositing aluminum oxide (Al2O3) in the third pores 331, and the insulating structure 400 is formed using silicon oxide (SiO2).

FIG. 5A shows an embodiment wherein the connection regions 313-323 extend above the porous structure 300 (similarly to the embodiment of FIG. 4A).

The top surface of the porous structure 300 is depicted with a solid line.

As illustrated on the dashed line, the intensity of the electrostatic field is relatively high: a field magnitude above 8.5 MV/cm is measured in the insulating layer 410.

This can adversely affect the breakdown voltage of the capacitor.

FIG. 5B shows an embodiment wherein the connection regions 313-323 are confined within the porous structure 300 (similarly to the embodiment of FIG. 2).

The top surface of the porous structure 300 is depicted with a solid line.

As illustrated on the dashed line, the intensity of the electrostatic field is relatively low: a field magnitude below 6 MV/cm is measured in the insulating layer 410.

This allows the capacitor to reliably withstand high voltages.

**FIG. 6** illustrates a top view of an electrical device according to an embodiment of the invention.

This figure illustrates that the layout of the first and second capacitor electrode regions 310-320. Here, the first and second capacitor electrode regions 310-320 are arranged in an interlocking-comb structure. The capacitor dielectric region 330 is interposed in between.

This arrangement of the capacitor electrodes maximizes the surface area of the porous structure 300 used to form the capacitor. An increased capacitance density follows as a result.

Within the scope of the present invention, other embodiments could be envisaged. For instance, the first and second capacitor electrode regions 310-320 could be arranged in an interlocking spiral structure.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

It is to be understood that references in this text to directions and locations, such as "top" and "bottom," or "front" and "rear," merely refer to the directions that apply when architectures and components are oriented as illustrated in the accompanying drawings.

## Claims

1. An electrical device (100) comprising a capacitor including a porous structure (300), the porous structure (300) comprising:
- a first capacitor electrode region (310) comprising first pores (311), wherein these first pores (311) comprise first conductive wires (312),
- a second capacitor electrode region (320) comprising second pores (321), wherein these second pores (321) comprise second conductive wires (322), and
- a capacitor dielectric region (330) comprising third pores (331) and interposed between the first and second capacitor electrode regions (310, 320),
wherein the capacitor is formed by the first pores (311) of the first capacitor electrode region (310) and the second pores (321) of the second capacitor electrode region (320) facing each other and being separated by the third pores (331) of the capacitor dielectric region (330).

2. The electrical device (100) of claim 1, wherein the first and second conductive wires (312, 322) fill the first and second pores (311, 321) of the first and second capacitor electrode regions (310, 320).

3. The electrical device (100) of claim 1, wherein the first and second conductive wires (312, 322) fill partially the first and second pores (311, 321) of the first and second capacitor electrode regions (310, 320), volumes remaining empty in (the center of) these pores (311, 321).

4. The electrical device (100) of any of claims 1 to 3, wherein the capacitor comprises:
- a first connection region (313) comprising conductive material electrically connecting the first conductive wires (312) of the first pores (311) of the first capacitor electrode region (310), and
- a second connection region (323) comprising conductive material electrically connecting the second conductive wires (322) of the second pores (321) of the second capacitor electrode region (320).

5. The electrical device (100) of claim 4, wherein:
- the first and second capacitor electrode regions (310, 320) comprise respectively first and second recesses so that a top surface of the first and second pores (311, 321) lies below a top surface of the porous structure (300), and
- the first and second connection regions (313, 323) extend respectively in the first and second recesses of the first and second capacitor electrode regions (310, 320) so that a top surface of the first and second connection regions (313, 323) lies below or at the level of the top surface of the porous structure (300).

6. The electrical device (100) of claim 4 or 5, wherein a thickness of the first and second connection regions (313, 323) is comprised between 100nm and 3µm.

7. The electrical device (100) of any of claims 1 to 6, wherein the porous structure (300) comprises pores (301) extending up to lateral edges of the electrical device (100).

8. The electrical device (100) of any of claims 1 to 7, wherein all or part of the third pores (331) of the capacitor dielectric region (330) comprise dielectric material (332).

9. The electrical device (100) of any of claims 1 to 8, wherein the first and second capacitor electrode regions (310, 320) are arranged in an interlocking-comb structure or an interlocking spiral structure.

10. The electrical device (100) of any of claims 1 to 9, wherein the electrical device (100) is configured to be used with an operating voltage measured between the first conductive wires (312) of the first capacitor electrode region (310) and the second conductive wires (322) of the second capacitor electrode region (320) exceeding 900V or 1200V.

11. A method for manufacturing an electrical device (100) comprising a capacitor, the method comprising:
- providing a porous structure (300),
- forming first conductive wires (312) in first pores (311) of a first capacitor electrode region (310) of the porous structure (300),
- forming second conductive wires (322) in second pores (321) of a second capacitor electrode region (320) of the porous structure (300), and
wherein:
- the porous structure (300) comprises a capacitor dielectric region (330) comprising third pores (331) and interposed between the first and second capacitor electrode regions (310, 320),
- the capacitor is formed by the first pores (311) of the first capacitor electrode region (310) and the second pores (321) of the second capacitor electrode region (320) facing each other and being separated by the third pores (331) of the capacitor dielectric region (330).

12. The method of claim 11, comprising:
- depositing, on the porous structure (300), a mask (HM1) comprising:
• at least one solid portion defining the first and second capacitor electrode regions (310, 320),
• at least one opening defining the capacitor dielectric region (330),
- depositing dielectric material (332) in the third pores (331) of the capacitor dielectric region (330), and
- removing the mask (HM1) before forming the first and second conductive wires (312, 322) in the first and second pores (311, 321) of the first and second capacitor electrode regions (310, 320).

13. The method of claim 11 or 12, comprising:
- etching first and second recesses respectively in the first and second capacitor electrode regions (310, 320) so that a top surface of the first and second pores (311, 321) of these regions (310, 320) lies below a top surface of the porous structure (300), and
- depositing a layer of conductive material (CL) on the porous structure (300) to form:
• a first connection region (313) extending in the first recesses of the first capacitor electrode region (310) and electrically connecting the first conductive wires (312) of this region (310), and
• a second connection region (323) extending in the second recesses of the second capacitor electrode region (320) and electrically connecting the second conductive wires (322) of this region (320),
- planarizing the layer of conductive material (CL) so that a top surface of the first and second connection regions (313, 323) lies below or at the level of the top surface of the porous structure (300).

14. The method of any of claims 11 to 13, wherein providing the porous structure (300) comprises anodizing an aluminum layer (AL) to form pores (301) on substantially an entire surface of this layer (AL).

15. The method of any of claims 11 to 14, comprising depositing dielectric material (332) in the third pores (331) of the dielectric region (330) using atomic layer deposition.
